# EUROPEAN PATENT SPECIFICATION

(11) **EP 4 407 592 B1**
(45) Date of publication and mention of the grant of the patent: **07.10.2026**
(21) Application number: 23784389.1
(22) Date of filing: 24.05.2023
(51) Int. Cl.: G06F 1/16, H04M 1/02, G09F 9/30

(54) **ELECTRONIC DEVICE**
ELEKTRONISCHE VORRICHTUNG
DISPOSITIF ÉLECTRONIQUE

(30) Priority: 08.04.2022 CN 202210397910
(43) Date of publication of application: 31.07.2024
(73) Proprietor: Honor Device Co., Ltd., Shenzhen, Guangdong 518040 (CN)
(72) Inventor: GUO, Renwei, Shenzhen, Guangdong 518040 (CN)
(74) Representative: Epping - Hermann - Fischer
(86) International application number: PCT/CN2023/096136
(87) International publication number: WO 2023/193828

(56) References cited:
- WO-A1-2021/000445
- WO-A1-2021/238461
- CN-A- 101 852 932
- CN-A- 106 710 452
- CN-A- 112 153 176
- CN-A- 114 863 808
- CN-U- 210 466 351
- CN-U- 215 934 895
- US-A1- 2019 380 197

## Description

This application claims priority to Chinese Patent Application No. 202210397910.2, filed with the China National Intellectual Property Administration on April 8, 2022 and entitled "SCREEN ASSEMBLY, ELECTRONIC DEVICE, AND ASSEMBLING METHOD".

### TECHNICAL FIELD

This application relates to the field of display technologies, and in particular, to a screen assembly, an electronic device, and an assembling method.

### BACKGROUND

Electronic devices such as a mobile phone and a tablet computer have components for image display, such as a display screen. In some cases, the display screen needs to be bent. In some known technologies, a bending region of the display screen is easily damaged by external impact.

WO 2021/000445 A1 relates to a display device comprising a middle frame and a display module located in the middle frame; the display module comprises a bent portion, and a first adhesive layer located on the bent portion; the bent portion is connected to the middle frame by means of the first adhesive layer.

CN 112 153 176 A relates to an electronic device which comprises a shell. The shell is provided with a first surface and a second surface adjacent to the first surface, the first surface is provided with a first groove body, and the second surface is provided with a second groove body communicated with the first groove body; the electronic device further comprises a display assembly, the display assembly is arranged on the shell and comprises a main body section, a bent section and an extending section which are connected in sequence, the main body section and the extending section are arranged in a stacked mode, the extending section is located between the main body section and the first surface, the extending section is embedded in the first groove body, the bent section is arranged in the second groove body, and a dispensing layer is arranged between the bent section and the inner wall of the second groove body.

### SUMMARY

This application provides a screen assembly, an electronic device, and an assembling method to resolve a problem that a bending region of the existing display screen is easily damaged by external impact.

The invention is set out in the appended claims.

According to a first aspect, an embodiment of this application provides a screen assembly, including a display screen, a cover plate, and a bracket. A surface of a side of the cover plate is a first plate surface. The display screen is located on a side at which the first plate surface of the cover plate is located, the display screen has a bent section that is formed by bending toward a side away from the cover plate. The bracket is located on a side of the display screen away from the cover plate. The bent section is located between the bracket and the cover plate.

In the embodiment of this application, the bent section is located between the bracket and the cover plate, so that the bent section can be protected from two sides, effectively reducing a possibility of the bent section being damaged by external impact.

In a possible implementation, the bracket and the cover plate form accommodating space. The display screen further includes a main screen section. The bent section is bent from an edge of the main screen section toward a side away from the cover plate. The main screen section is at least partially located outside the accommodating space. The bent section extends from the main screen section into the accommodating space.

In this implementation, the bent section extends into the accommodating space that is formed by the bracket and the cover plate, so that the bent section can be protected reliably.

In a possible implementation, the accommodating space is filled to form a filling structure, configured to fix the bent section in the accommodating space.

In this implementation, the bent section is fixed in the accommodating space by the filling structure, which provides reliable protection to the bent section.

In a possible implementation, the bracket includes a bracket body and a first raised part. The bracket body is spaced apart from and opposite to the display screen. The first raised part protrudes from the bracket body toward a surface of a side of the cover plate.

In this implementation, a raised first raised part may directly or indirectly support the display screen to support the display screen and support a main bracket plate away from the display screen, so that there is space with a specific thickness between the display screen and the main bracket plate. The space is used, by using a material such as filling adhesive to form the filling structure that wraps the bent section of the display screen, which provides a better protection to the bent section.

In a possible implementation, a surface that is of the first raised part and that corresponds to the display screen is a first surface. First supporting pads are disposed on the first surface, so that the first surface is spaced apart from the display screen to define a first gap. The first gap is communicated with the accommodating space.

In this implementation, with the first supporting pads, the display screen may be supported on the first supporting pads during assembly to form the first gap, communicated with the accommodating space, between the first surface and the display screen, so that when adhesive is poured into the accommodating space, air in the accommodating space may be discharged from the first gap, thereby facilitating filling with an adhesive material. In addition, an excessive adhesive material may be poured to make the adhesive material overflow from the first gap to ensure that the adhesive material in the accommodating space is filled, and the adhesive material left in the first gap may be used to bond the first surface/the first supporting pads and the display screen.

In a possible implementation, there are a plurality of first supporting pads. The plurality of first supporting pads are disposed at intervals in sequence. The first gap includes interval space between adjacent first supporting pads.

In this implementation, the adhesive material is filled between adjacent first supporting pads, which increases a contact area between the adhesive material and the bracket and improves bonding strength.

In a possible implementation, the first supporting pads are made of a flexible material.

This implementation can avoid a rigid structure crushing the display screen or applying excessive stress.

In a possible implementation, the bracket includes a second raised part. The second raised part protrudes from the bracket body toward the cover plate. The second raised part and the first raised part are spaced apart from each other. The accommodating space is located between the first raised part and the second raised part.

In this implementation, the first raised part and the second raised part can not only support the display screen and the cover plate, but also define two ends of the accommodating space, which is convenient for filling to form the filling structure.

In a possible implementation, the cover plate includes a cover plate body covering the display screen and an extended plate section extending outward beyond the bent section from one end of the cover plate body near the bent section. The second raised part protrudes from the bracket body toward the extended plate section.

In this implementation, a raised second raised part may directly or indirectly support the cover plate to implement positioning of the bracket with the first raised part during installation, and is blocked outside the bent section in inner and outer directions, so that the filling structure includes a part filled between the second raised part and the bent section, which is used to protect the bent section.

In a possible implementation, a surface that is of the second raised part and that corresponds to the extended plate section is a second surface. Second supporting pads are convexly disposed on the second surface. The second supporting pads support the extended plate section, so that the second surface is spaced apart from the extended plate section to define a second gap. The second gap is communicated with the accommodating space.

In this implementation, with the second supporting pads, the extended plate section of the cover plate may be supported on the second supporting pads during assembly to form the second gap, communicated with the accommodating space between the second surface and the extended plate section, so that when adhesive is poured into the accommodating space, air in the accommodating space may be discharged from the second gap, thereby facilitating filling with an adhesive material. In addition, an excessive adhesive material may be poured to make the adhesive material overflow from the second gap to ensure that the adhesive material in the accommodating space is filled, and the adhesive material left in the second gap may be used to bond the second surface/the second supporting pads and the extending plate section.

In a possible implementation, there are a plurality of second supporting pads. The plurality of second supporting pads are disposed at intervals in sequence. The second gap includes interval space between adjacent second supporting pads.

In this implementation, the adhesive material is filled between adjacent second supporting pads, which increases a contact area between the adhesive material and the bracket and improves bonding strength.

In a possible implementation, the second raised part extends to an end surface of the cover plate. The second raised part is opposite to the end surface of the cover plate.

In this implementation, the second raised part is relatively more protruding, occupying thickness space of the cover plate.

In a possible implementation, a surface that is of the second raised part and that corresponds to the end surface of the cover plate is a third surface. The third surface is spaced apart from end surface of the cover plate to define a third gap. The third gap is communicated with the accommodating space.

In this implementation, when adhesive is poured into the accommodating space through the third gap, air in the accommodating space may be discharged from the third gap, facilitating filling with an adhesive material. In addition, an excessive adhesive material may be poured to make the adhesive material overflow from the third gap to ensure that the adhesive material in the accommodating space is filled, and the adhesive material left in the third gap may be used to bond the third surface and the end surface of the cover plate.

In a possible implementation, the cover plate includes the cover plate body and the extended plate section that are connected to each other. The display screen includes the main screen section, a wire connecting screen section, and the bent section. The bent section is connected between the main screen section and the wire connecting screen section. The main screen section is used for on-screen display. The wire connecting screen section is configured to connect a wire of the display screen. The main screen section is attached to an inner side surface of the cover plate body. The wire connecting screen section is located on an inner side surface of the main screen section, and is stacked on the main screen section. The extended plate section extends beyond the main screen section. The first raised part corresponds to the wire connecting screen section, and the first gap is defined between the first raised part and the wire connecting screen section. The second raised part corresponds to the extended plate section, and the second gap is defined between the second raised part and the extended plate section. The bracket body is spaced apart from and opposite to the wire connecting screen section to define first filling space. The second raised part is spaced apart from and opposite to the bent section to define second filling space. The second filling space is communicated with the first filling space. The first gap is communicated with the first filling space. The second gap is communicated with the second filling space. The accommodating space includes the first filling space and the second filling space.

In this implementation, by filling the first filling space and the second filling space with an adhesive material, the first filling space, the second filling space, the first gap, and the second gap are filled, so that the display screen, the bracket, and the cover plate are bonded into an integral structure, which greatly improves a protection effect of the bent section of the display screen in the accommodating space. In addition, the first gap and the second gap that are communicated with the accommodating space are also conducive to outflow of gas in the accommodating space during adhesive filling, reducing a possibility that air bubbles left in the accommodating space affect the adhesive material filling, and then affect the bonding effect and cushioning protection effect.

In a possible implementation, an inward recessed cavity is formed on a surface of the bent section away from a side of the cover plate before bending. In a bending state of the display screen, the recessed cavity defines a third filling space. The accommodating space includes the third filling space.

In this implementation, when an adhesive material is poured into the accommodating space, the adhesive material may be filled into the third filling space. There is an adhesive material on an inner side of the bent section, which limits the bent section to further bend, and reduces a possibility of damage at a corner caused by excessive bending of the bent section. Combined with the adhesive material wrapped on an outer side of the bent section, the bent section can be reliably maintained in a preset bent state, and a possibility of affecting structural performance of a bent screen section by a change of a bending angle of the external force is reduced.

In a possible implementation, the cover plate includes a flat plate section and an arcuate plate section. The arcuate plate section is formed by bending and extending in an arc direction from an edge of the flat plate section. The cover plate body includes the flat plate section and a part of the arcuate plate section connected to the flat plate section. The extended plate section is a part of the arcuate plate section extending beyond the bent section. A curved angle of the arcuate plate section is from 90° to 180°. The main screen section includes a flat section and a curved section that are connected to each other. The bent section is connected to one end of the curved section away from the flat section. The flat section fits on a side on the flat plate section at which the first plate surface is located. The curved section fits on a side on the arcuate plate section at which the first plate surface is located. A shape of the wire connecting screen section includes an arc shape fitting with the curved section. The wire connecting screen section is stacked on an inner side surface of the curved section. The first raised part corresponds to a junction of the flat section and the curved section. An angle between a tangent direction at one end of the curved section connected to the bent section and the flat section is 90° to 180°.

In this implementation, a curved angle of the arcuate plate section and the curved section is beneficial to a design of an all-screen display of the electronic device.

According to a second aspect, an embodiment of this application provides a screen assembly assembling method, for forming the foregoing screen assembly. The screen assembly assembling method includes:
The bracket and the cover plate form the accommodating space, and the bent section is formed by bending the display screen and is accommodated in the accommodating space.

In addition, the filling structure is formed by pouring adhesive into the accommodating space to fix the bent section in the accommodating space.

The screen assembly assembling method in the embodiment of this application can form the foregoing screen assembly.

In a possible implementation, one end of the bracket is spaced corresponding to the display screen, and a gap that is communicated with the accommodating space is defined between one end of the bracket and the display screen. The other end of the bracket is spaced corresponding to the cover plate, and a gap that is communicated with the accommodating space is defined between the other end of the bracket and the cover plate. When adhesive is poured into the accommodating space, an adhesive material is filled into the gaps from the accommodating space.

In this implementation, when adhesive is poured into the accommodating space, the adhesive material may be filled from the accommodating space to a first gap and/or a second gap, to facilitate gases discharge in the accommodating space and bonding of a structure on both sides of the first gap/second gap. An adhesive material that overflows the first gap and the second gap may be removed by subsequent processes.

In a third aspect, an embodiment of this application provides an electronic device, including a rear cover and the screen assembly. The rear cover and the cover plate are fitted to form internal space to accommodate internal components of the electronic device.

The electronic device in the embodiment of this application uses the foregoing screen assembly, so that the bent section can be protected reliably effectively reducing a possibility of the bent section being damaged by external impact.

In a possible implementation, the display screen is located between the rear cover and the cover plate. The rear cover has a rear cover end facing the cover plate. The bracket is disposed at the rear cover end.

In this implementation, the display screen is located between the rear cover and the cover plate. The bracket is disposed at the rear cover end, which can provide reliable protection for the display screen.

According to a fourth aspect, an embodiment of this application provides an electronic device, including a display screen, a cover plate, and a rear cover. A surface of a side of the cover plate is a first plate surface. The display screen is located on a side of the first plate surface of the cover plate. The display screen has a bent section that is formed by bending toward a side away from the cover plate. The rear cover includes a cover body and a supporting part. The cover body and the cover plate are fitted to form internal space. The display screen is located in the internal space. The cover body has a rear cover end facing the cover plate. The supporting part is connected to the rear cover end and extends into the internal space. The bent section is located between the supporting part and the cover plate.

In the embodiment of this application, provision of the supporting part and the cover plate on the rear cover to support and protect the display screen together, safety to use the display screen can be effectively improved.

In a possible implementation, the supporting part is a cantilever structure protruding from the rear cover end. A wall thickness of the supporting part is 0.5 mm to 1.0 mm.

In this implementation, the supporting part is cantilevered out from the rear cover end. When the supporting part or a whole rear cover is made by using a specific elastic material (such as a metal sheet and a plastic material with a specific elasticity), a cantilever extension part of the supporting part has specific elastic deformability. In this way, a supporting arm provides elastic support for the display screen, and therefore not only supports the display screen but also provides certain cushioning protection for the display screen.

In a possible implementation, the supporting part is connected to a side of the rear cover end near the internal space.

In this implementation, the supporting part is connected to a side of the rear cover end near the internal space, which is convenient for the supporting part to extend into the internal space and the cover plate to protect the bent section of the display screen.

In a possible implementation, the supporting part is spaced apart from and opposite to the cover plate to define the accommodating space. The display screen further includes a main screen section. The bent section is bent from an edge of the main screen section toward a side away from the cover plate. The main screen section is at least partially located outside the accommodating space. The bent section extends from the main screen section into the accommodating space.

In this implementation, the supporting part and the cover plate form the accommodating space, so that the bent section can be reliably protected.

In a possible implementation, the accommodating space is provided with a filling structure, configured to fix the bent section on the supporting part and/or the cover plate.

In this implementation, after the rear cover is assembled in place, only one adhesive bonding is needed to implement formation of the filling structure used to protect the display screen and to bond the rear cover and the cover plate. Operation steps are reduced.

In a possible implementation, a side of the supporting part away from the rear cover end has a first raised part protruding to a side of the display screen.

In this implementation, the first raised part is disposed on a side of the supporting part away from the rear cover end, that is, at a cantilever end of the supporting part, making a function of elastic supporting of the display screen.

In a possible implementation, a surface that is of the first raised part and that corresponds to the display screen is a first surface. First supporting pads are disposed on the first surface, so that the first surface is spaced apart from the display screen to define a first gap. The first gap is communicated with the accommodating space.

In this implementation, with the first supporting pads, the display screen may be supported on the first supporting pads during assembly to form the first gap, communicated with the accommodating space, between the first surface and the display screen, so that when adhesive is poured into the accommodating space, air in the accommodating space may be discharged from the first gap, thereby facilitating filling with an adhesive material. In addition, an excessive adhesive material may be poured to make the adhesive material overflow from the first gap to ensure that the adhesive material in the accommodating space is filled, and the adhesive material left in the first gap may be used to bond the first surface/the first supporting pads and the display screen.

According to a fifth aspect, an embodiment of this application provides an electronic device assembling method, for forming the foregoing electronic device. The electronic device assembling method includes:
The rear cover and the cover plate are assembled, so that the accommodating space is defined between the supporting part and the cover plate, and the bent section formed by bending the display screen is accommodated in the accommodating space.

In addition, the filling structure is formed by pouring adhesive into the accommodating space.

The electronic device assembling method in the embodiment of this application can form the foregoing electronic device.

In a possible implementation, a first gap is retained between an end surface corresponding to the rear cover and the cover plate, and a second gap is retained between a side of the supporting part away from a rear cover end and the display screen. When adhesive is poured into the accommodating space, an adhesive material is filled from the accommodating space into the first gap and the second gap.

In this implementation, by filling the accommodating space with an adhesive material, the accommodating space, the first gap, and the second gap are filled by the adhesive material, so that the display screen, the bracket, and the cover plate are bonded into an integral structure, which greatly improves a protection effect of the bent section of the display screen in the accommodating space. In addition, the first gap and the second gap that are communicated with the accommodating space are also conducive to outflow of gas in the accommodating space during adhesive filling, reducing a possibility that air bubbles left in the accommodating space affect the adhesive material filling, and then affect the bonding effect and cushioning protection effect.

### BRIEF DESCRIPTION OF DRAWINGS

To describe the technical solutions of embodiments of this application more clearly, the following briefly describes the accompanying drawings of embodiments. It should be understood that the following accompanying drawings show only some embodiments of this application, which cannot be considered as limitation on the scope. A person of ordinary skill in the art may still derive other accompanying drawings from the accompanying drawings without creative efforts.
FIG. 1 is a schematic diagram of an electronic device according to an embodiment of this application;
FIG. 2 is a sectional view of the electronic device in FIG. 1 along a line A-A;
FIG. 3 is a three-dimensional view of a bracket in FIG. 2;
FIG. 4 is a schematic diagram of the electronic device in FIG. 2 after a partial structure is hidden;
FIG. 5 is a schematic diagram of a structure of a second raised part in FIG. 2 when being arranged in another way (part of the structure is not shown);
FIG. 6 is a three-dimensional view of a bracket in FIG. 5;
FIG. 7 is a schematic diagram of a structure of an electronic device according to an example implementation;
FIG. 8 is an axonometric diagram of a screen assembly in FIG. 7;
FIG. 9 is a view of a structure of a screen assembly in FIG. 7 after a partial structure of a filling structure is hidden;
FIG. 10 is a three-dimensional view of a bracket in FIG. 7;
FIG. 11 is a view of a partial structure of an electronic device according to an example implementation; and
FIG. 12 is a three-dimensional view of a bracket in FIG. 11;

**Reference numerals of main elements:**

| | |
|---|---|
| electronic device | 10, 10a |
| screen assembly | 11 |
| rear cover | 12, 12a |
| battery | 13 |
| mainboard | 14 |
| mainboard support | 15 |
| display screen | 16 |
| bent section | 16a |
| main screen section | 16b |
| wire connecting screen section | 16c |
| flat section | 16m |
| curved section | 16n |
| cover plate | 17 |
| cover plate body | 17a |
| extended plate section | 17b |
| flat plate section | 17m |
| arcuate plate section | 17n |
| bracket | 18 |
| filling structure | 19 |
| wire | 20 |
| bracket body | 21 |
| first raised part | 22 |
| first supporting pad | 23 |
| second raised part | 24 |
| second supporting pad | 25 |
| cover body | 26 |
| supporting part | 27 |
| rear cover end | 28 |
| bonding part | 29 |
| recessed cavity | C1 |
| first gap | f1 |
| second gap | f2 |
| third gap | f3 |
| fourth gap | f4 |
| fitting gap | f5 |
| first surface | P1 |
| second surface | P2 |
| third surface | P3 |
| end surface | P4 |
| first plate surface | P6 |
| second plate surface | P5 |
| Internal space | Q1 |
| accommodating space | Q2 |
| first filling space | Q3 |
| second filling space | Q4 |
| third filling space | Q5 |
| dividing line | L1, L2 |

### DESCRIPTION OF EMBODIMENTS

The technical solutions in embodiments of this application are clearly and completely described below with reference to the accompanying drawings in embodiments of this application. Apparently, the described embodiments are merely some rather than all of embodiments of this application.

It should be noted that when a component is referred to as "being fixed to" another component, the component may be directly on the another component, or an intermediate component may exist. When a component is considered to be "connected to" another component, the component may be directly connected to the another component, or an intermediate component may also exist. When a component is considered to be "disposed" on another component, the component may be directly disposed on the another component or an intermediate component may also exist. The terms "vertical", "horizontal", "left", and "right" and similar expressions used in this specification are merely used for the purpose of description.

Unless otherwise defined, meanings of all technical and scientific terms used in this specification are the same as that usually understood by a person skilled in the art to which this application belongs. In this specification, terms used in the specification of this application are merely intended to describe objectives of the specific implementations, but are not intended to limit this application. The term "or/and" used in this specification includes any or all combinations of one or more related listed items.

Some implementations of this application are described in detail. The following implementations and features in the implementations may be combined with each other in the case of no conflict.

### Embodiment

Some electronic devices with known technologies, to reduce influence of wire outlet of a display screen on an on-screen display area, the display screen has a bending part. The bending part of the display screen in the known technologies is easily damaged by external impact. For example, for an electronic device with a cover plate on the display screen, under an action of an external force facing the cover plate, the bending part is prone to deformation and damage due to the bending effects on strength. This embodiment provides a screen assembly that may be used in electronic devices such as a mobile phone, a tablet computer, a smart watch, and a laptop. The screen assembly can reduce deformation of the bending part when the electronic device is subjected to external force, thereby reducing a possibility of damage to the display screen.

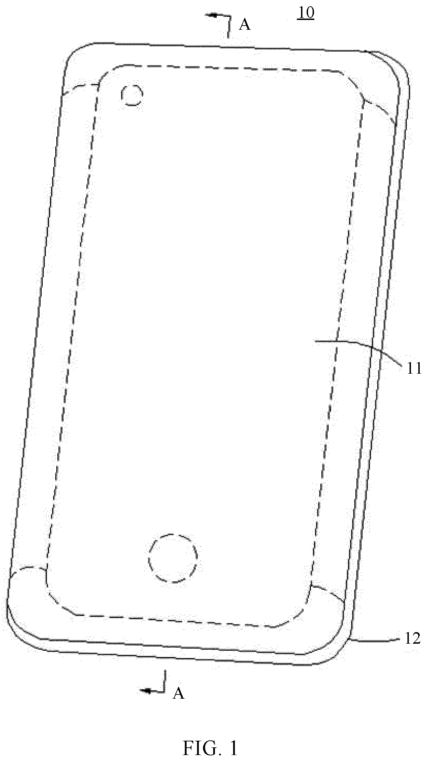

Using the mobile phone as an example, the electronic device 10 (the mobile phone) shown in FIG. 1 includes a screen assembly 11 and a rear cover 12. The screen assembly 11 is located on the front of the electronic device 10 and is mainly used for image display. The rear cover 12 is located on the back of the electronic device 10 and is connected to the screen assembly 11.

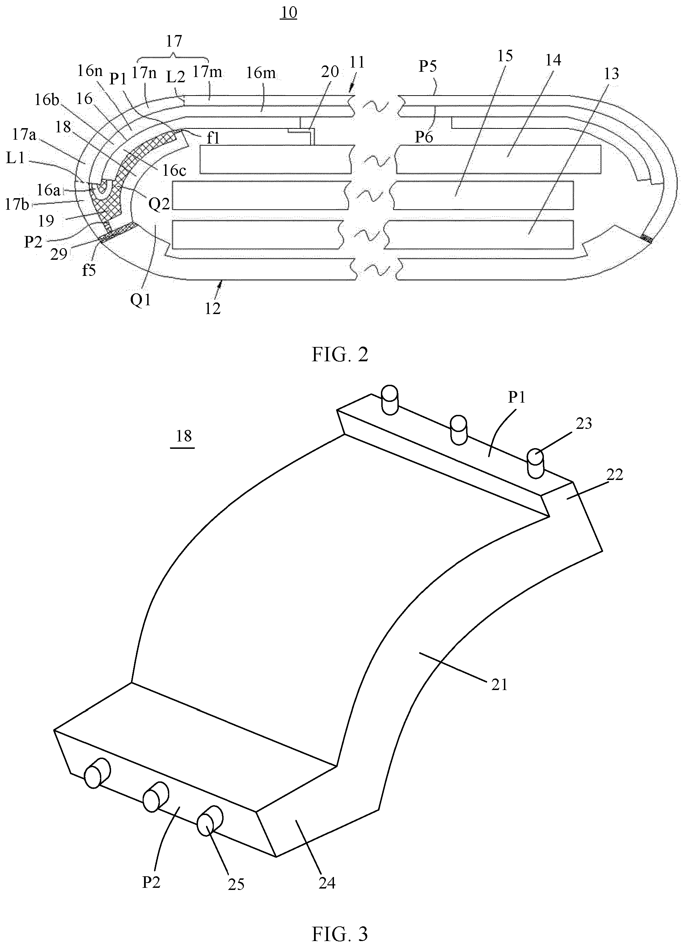

Refer to FIG. 2. The rear cover 12 and the screen assembly 11 together form internal space Q1, configured to accommodate internal components of electronic device 10, such as a battery 13, mainboard 14, and mainboard support 15. The "front" and "back" mentioned here are only relative concepts of the electronic device 10 (the mobile phone) and are not limited. Generally, one side of a screen of the electronic device 10 is the front, while the other side of the electronic device is the back.

Still refer to FIG. 2. The screen assembly 11 in this implementation includes a display screen 16, a cover plate 17, and a bracket 18. The display screen 16 may be electrically connected to the mainboard 14 through a wire 20 to implement data exchange between the display screen 16 and the mainboard 14. The wire 20 may be a flexible circuit board.

In some implementation methods, the display screen 16 and the wire 20 may be disposed as an integral structure. For example, a substrate (not shown) of the display screen 16 is extended to a length to be used as a substrate of the wire 20, and a circuit (not shown) configured to connect the display screen 16 to the mainboard 14 electrically is arranged on the extended substrate. In other embodiments, a separate flexible circuit board may alternatively be used as the wire 20 to connect the display screen 16 and the mainboard 14.

The cover plate 17 may be a glass cover plate or other transparent cover plate structures. The cover plate 17 can provide some protection for the display screen 16. The cover plate 17 has a first plate surface P6 and a second plate surface P5 that are opposite to each other. The first plate surface P6 and the second plate surface P5 are respectively surfaces on both sides of the cover plate 17 along a thickness direction. The first plate surface P6 shown in FIG. 2 faces inward and is close to the internal space Q1. The second plate surface P5 is outward and away from the internal space Q1.

The display screen 16 may be a flexible screen structure, such as an OLED screen. The display screen 16 is located on a side of the first plate surface P6 of the cover plate 17 (that is, an inner side). The display screen 16 includes a main screen section 16b and a bent section. The main screen section 16b is connected to the inner side of the cover plate 17. The bent section 16a is bent from an edge of the main screen section 16b toward a side away from the cover plate 17.

The bracket 18 is located on a side of the display screen 16 away from the cover plate 17 and forms accommodating space Q2 with the cover plate 17. The bent section 16a is located between the bracket 18 and the cover plate 17, and extends into the accommodating space Q2. A filling structure 19 is provided in the accommodating space Q2, and is configured to fix the bent section 16a in the accommodating space Q2. A part of the main screen section 16b connecting to one end of the bent section 16a may also be extended into the accommodating space Q2 and fixed in the accommodating space Q2 by the filling structure 19. Certainly, an outer surface of the main screen section 16b (close to a surface of a side of the cover plate 17) is not covered by the filling structure 19 to maintain a display function.

In the embodiment of this application, the bent section 16a of the screen assembly 11 is accommodated in the accommodating space Q2 formed by the bracket 18 and the cover plate 17, and is fixed to the bracket 18 and the cover plate 17 by the filling structure 19. The fragile bent section 16a, the bracket 18, and the cover plate 17 of the display screen 16 are fixed together by the filling structure 19, which can give reliable protection to the bent section 16a and effectively reduce a possibility of the bent section 16a being damaged by external impact. In this embodiment, the filling structure 19 is formed by pouring adhesive into the accommodating space Q2 in which the bent section 16a is already accommodated. The poured adhesive may be an adhesive material with good fluidity before pouring and be cured after pouring (such as curing by heating) to implement the bent section 16a, the bracket 18, and the cover plate 17 being bonded near the bent section 16a.

In other example embodiments, not according to the invention as claimed, the filling structure 19 may be replaced by a non-adhesive material other than an adhesive material. In some embodiments, a capability of the bent section 16a to resist external impact may be improved by only supporting the display screen 16 through the bracket 18 without provision of the filling structure 19.

The display screen 16 with the bent section 16a obtained by bending the display screen 16 has some usage scenarios. For example, a side edge of the display screen 16 may be folded back 180°, and the wire 20 is disposed at the edge of a folded back part. In this way, the wire 20 is located on the back of an unfolded part of the display screen 16, which does not affect a display area of the front of the display screen 16, so that a surface of the display screen 16 facing the outside may be used for display, which is beneficial to the electronic device 10 to obtain a larger front display region, and even to obtain an all-screen electronic device 10. The wire 20 in this embodiment is located at the bottom of the electronic device 10 (from the perspective of FIG. 1). In other words, the display screen 16 is drawn from the bottom of the electronic device 10. In some other embodiments, a wire outlet position of the display screen 16 may alternatively be located at the top or side of the electronic device 10.

Refer to FIG. 2 and FIG. 3. The bracket 18 in this embodiment includes a bracket body 21, a first raised part 22, and a second raised part 24.

The bracket body 21 is roughly a plate-like structure. An extension direction of the bracket body is consistent with an extension direction of a corresponding part of the cover plate 17 and the display screen 16. For example, in the implementations shown in FIG. 2 and FIG. 3, the cover plate 17 and the display screen 16 are arc-shaped at a corresponding position of the bracket body 21. In addition, the bracket body 21 is roughly of an arc plate-like structure. In other implementations, the bracket body 21 may alternatively be disposed in other shapes, and does not need to be completely consistent with the extension direction of the cover plate 17 or the display screen 16. A thickness of the bracket body 21 may be disposed as needed. In this implementation, the thickness of the bracket body 21 is 0.5 mm to 1.0 mm to ensure structural strength of the bracket body and occupy small space.

The first raised part 22 and the second raised part 24 are located at two ends of the extension direction of the bracket body 21 respectively, are spaced apart from each other, and protrude from a side of the bracket body 21 to the cover plate 17. The first raised part 22 correspondingly supports the display screen 16, the second raised part 24 corresponds to the cover plate 17, and the bracket body 21 is spaced apart from and opposite to the cover plate 17, so that the first raised part 22, the bracket body 21, the second raised part 24, and the cover plate 17 may form the accommodating space Q2 together, and the bent section 16a of the display screen 16 extends into the accommodating space Q2 from a gap between the first raised part 22 and the cover plate 17. For an arc plate-like bracket body 21, the first raised part 22 and the second raised part 24 are both roughly strip raised parts. A raised first raised part 22 may directly or indirectly support the display screen 16 to support the display screen 16, and a raised second raised part 24 may directly or indirectly support the cover plate 17 to support the cover plate 17. The first raised part 22 and the second raised part 24 may support the bracket body 21 away from the display screen 16, so that there is space with a specific thickness between the display screen 16 and the bracket body 21. The space is used, by using a material such as filling adhesive to form the filling structure 19 that wraps the bent section 16a of the display screen 16, which provides a better protection to the bent section 16a.

In some other implementations, the second raised part 24 may not be disposed, while the accommodating space Q2 is kept open at that end or closed by other structures of the electronic device 10 (such as the rear cover 12).

In some other implementations, the first raised part 22 may also not be disposed, while the accommodating space Q2 is kept open at that end or closed by other structures of the electronic device 10.

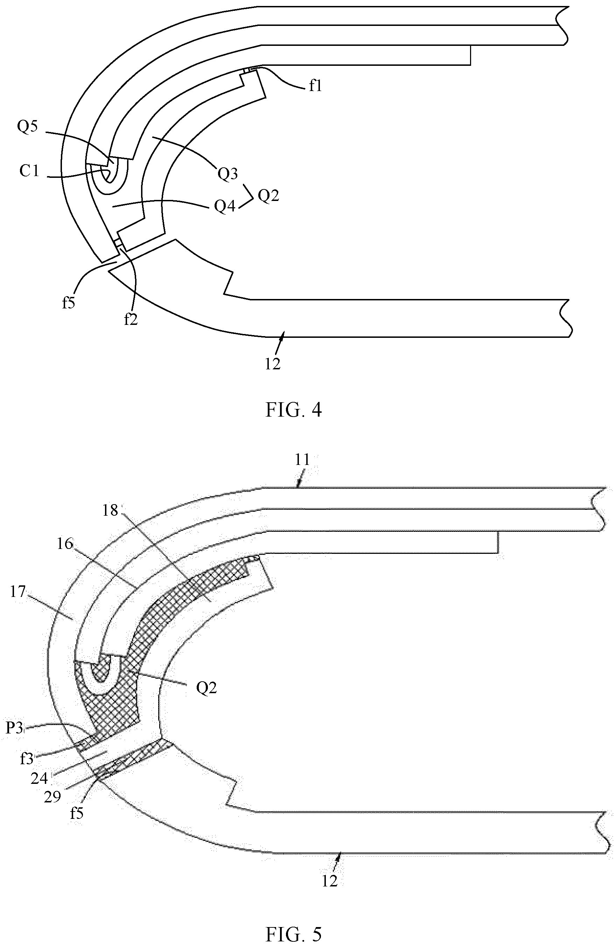

Still refer to FIG. 2 and FIG. 3. In this embodiment, a surface of the first raised part 22 corresponding to a side of the display screen 16 is a first surface P1. First supporting pads 23 are disposed on the first surface P1, and the first supporting pads 23 support the display screen 16, so that the first surface P1 is spaced apart from the display screen 16 to define a first gap f1 (also shown in FIG. 4). The first gap f1 is communicated with the accommodating space Q2. With the first supporting pads 23, the display screen 16 may be supported on the first supporting pads 23 during assembly to form the first gap f1, communicated with the accommodating space Q2, between the first surface P1 and the display screen 16, so that when adhesive is poured into the accommodating space Q2, air in the accommodating space Q2 may be discharged from the first gap f1, thereby facilitating filling with an adhesive material. In addition, an excessive adhesive material may be poured to make the adhesive material overflow from the first gap f1 to ensure that the adhesive material in the accommodating space Q2 is filled, and the adhesive material left in the first gap f1 may be used to bond the first surface P1, the first supporting pads 23, and the display screen 16. Optionally, there are a plurality of first supporting pads 23, and the plurality of first supporting pads 23 are disposed at intervals in sequence. An adhesive material filled in the first gap f1 may wrap each first supporting pad 23. For example, for the arc plate-like bracket body 21, the first raised part 22 is a strip raised part. The plurality of first supporting pads 23 may be disposed at intervals along a length direction of the first raised part 22. In this way, an adhesive material is filled between adjacent first supporting pads 23, which increases a contact area between the adhesive material and the bracket 18 and improves bonding strength. The first supporting pads 23 are made of a flexible material in this embodiment to avoid a rigid structure crushing the display screen 16 or applying excessive stress. Optionally, the first supporting pads 23 may be made of a soft rubber structure, and has a specific structure stiffness, can maintain a basic shape. Optionally, the first supporting pads 23 are made of an adhesive material with a specific bonding capability, such as hot melt adhesive. In this way, when the bracket 18 is installed, the first supporting pads 23 may be pre-bonded to the display screen by heating the first supporting pads 23, to implement pre-positioning of the bracket 18. Then, the step of pouring adhesive to the accommodating space Q2 is performed. Certainly, the pre-positioning of the bracket 18 may alternatively be implemented in a way that the bracket 18 presses the display screen 16 by using other top-pressure structures. In other implementations, the first surface P1 may directly contact the display screen 16, and the first gap f1 may be omitted. Alternatively, the first supporting pads 23 is not disposed, so that the first surface P1 and the display screen 16 do not contact directly and do not support through other structures, facilitating maintaining air exclusion and adhesive overflow effect of the first gap f1. Still refer to FIG. 2. In this embodiment, the cover plate 17 includes a cover plate body 17a covering the display screen 16 and an extended plate section 17b extending outward beyond the bent section 16a from one end of the cover plate body 17a near the bent section 16a. The cover plate body 17a and the extended plate section 17b may be two regions of a complete cover plate 17. A division position may be located at an extended end of the display screen 16 on the cover plate 17, such as a dividing line L1 as shown in FIG. 2. In other words, the part of the cover plate 17 covered by the display screen 16 is defined as the cover plate body 17a, and the part that does not correspond to the display screen 16 is defined as the extended plate section 17b. The second raised part 24 corresponds to the extended plate section 17b. For an arc plate-like bracket body 21, the second raised part 24 is roughly a strip raised part. A raised second raised part 24 may directly or indirectly support the cover plate 17 to implement positioning of the bracket 18 with the first raised part 22 during installation. The second raised part 24 is spaced apart from and opposite to the bent section 16a, so that the filling structure 19 includes a part filled between the second raised part 24 and the bent section 16a, which can give reliable protection to a curved point of the bent section 16a. In some implementations, the second raised part 24 has a second surface P2 corresponding to the extended plate section 17b. Second supporting pads 25 are convexly disposed on the second surface P2. The second supporting pads 25 support the extended plate section 17b, so that the second surface P2 is spaced apart from the extended plate section 17b to define a second gap f2. The second gap f2 is communicated with the accommodating space Q2. With the second supporting pads 25, an inner wall of the extended plate section 17b of the cover plate 17 may be supported on the second supporting pads 25 during assembly to form the second gap f2, communicated with the accommodating space Q2, between the second surface P2 and the extended plate section 17b, so that when adhesive is poured into the accommodating space Q2, air in the accommodating space Q2 may be discharged from the second gap f2, thereby facilitating filling with an adhesive material. In addition, an excessive adhesive material may be poured to make the adhesive material overflow from the second gap f2 to ensure that the adhesive material in the accommodating space Q2 is filled, and the adhesive material left in the second gap f2 may be used to bond the second surface P2, the second supporting pads 25, and the extended plate section 17b. Optionally, there are a plurality of second supporting pads 25, and the plurality of second supporting pads 25 are disposed at intervals in sequence, so that an adhesive material filled in the second gap f2 wraps each second supporting pad 25. For example, for the strip raised part 24, the plurality of the second supporting pads 25 may be disposed at intervals along a length direction of the second raised part 24. In this way, an adhesive material is filled between adjacent second supporting pads 25, which increases a contact area between the adhesive material and the bracket 18 and improves bonding strength. The second supporting pads 25 are made of a flexible material in this embodiment to avoid a rigid structure crushing the display screen 16 or applying excessive stress. Optionally, the second supporting pads 25 may be made of a soft rubber structure, and has a specific structure stiffness, can maintain a basic shape. Optionally, the second supporting pads 25 are made of an adhesive material with a specific bonding capability, such as hot melt adhesive. In this way, when the bracket 18 is installed, the second supporting pads 25 may be pre-bonded to the extended plate section 17b by heating the second supporting pads 25, to implement pre-positioning of the bracket 18. Then, the step of pouring adhesive to the accommodating space Q2 is performed. Certainly, the pre-positioning of the bracket 18 may alternatively be implemented in a way that the bracket 18 presses the extended plate section 17b by using other top-pressure structures.

In other implementations, the second surface P2 may directly contact an inner side surface of the extended plate section 17b, and the second gap f2 may be omitted. Alternatively, the second supporting pads 25 is not disposed, so that the second surface P2 and the inner side surface of the extended plate section 17b do not contact directly and do not support through other structures, facilitating maintaining air exclusion and adhesive overflow effect of the second gap f2.

Still refer to FIG. 2. In this embodiment, a fitting gap f5 is defined between the rear cover 12 and the screen assembly 11, and a bonding part 29 is formed by filling a glue material in the fitting gap f5, to bond the rear cover 12 and the screen assembly 11. For provision shown in FIG. 2, there is an implementation corresponding to the second raised part 24 of the extended plate section 17b. The second raised part 24 in the screen assembly 11 corresponding to a side surface of the rear cover 12 and the cover plate 17 corresponding to a side surface of the rear cover 12 bond to corresponding end surfaces of the rear cover 12, respectively. In the implementation shown in FIG. 2, the bracket 18 may be first connected to the display screen 16 and the cover plate 17 and poured adhesive to form an integrated screen assembly 11. Then, the screen assembly 11 is assembled with the rear cover 12 as a whole, and a glue material is filled in the fitting gap f5 to connect the screen assembly 11 and the rear cover 12. Certainly, an implementation that the second gap f2 is disposed and the accommodating space Q2 is communicated with the fitting gap f5 through the second gap f2 may alternatively be implemented by overflowing poured adhesives in the accommodating space Q2 into the fitting gap f5, to complete bonding of the bracket 18, the display screen 16, the cover plate 17, and the rear cover 12 at one time, which reduces assembling steps and improves assembling efficiency.

In implementations shown in FIG. 2 to FIG. 4, the second surface P2 of the second raised part 24 corresponds to the inner side surface of the extended plate section 17b of the cover plate 17, while FIG. 5 shows another disposing manner of the second raised part 24.

Still refer to FIG. 5. In this implementation, the second raised part 24 extends to an end surface of the cover plate 17. A side surface of the second raised part 24 is opposite to the end surface of the cover plate 17. A difference between the implementation and the implementations in FIG. 2 to FIG. 4 is that a protrusion height of the second raised part 24 in the implementer is larger, occupying thickness space of the cover plate 17, and a surface of the second raised part 24 corresponding to the cover plate 17 is a side surface rather than the end surface (that is, the second surface P2). Optionally, a surface that is of the second raised part 24 and that corresponds to the end surface of the cover plate 17 is a third surface P3. The third surface P3 is spaced apart from end surface of the cover plate 17 to define a third gap f3. The third gap f3 is communicated with the accommodating space Q2. When adhesive is poured into the accommodating space Q2 through the third gap f3, air in the accommodating space Q2 may be discharged from the third gap f3, facilitating filling with an adhesive material. In addition, an excessive adhesive material may be poured to make the adhesive material overflow from the third gap f3 to ensure that the adhesive material in the accommodating space Q2 is filled, and the adhesive material left in the third gap f3 may be used to bond the third surface P3 and the end surface of the cover plate 17. For the implementation shown in FIG. 5, a side surface of the second raised part 24 away from the cover plate 17 fits with an end surface of the rear cover 12 of the electronic device 10. The fitting gap f5 between the rear cover 12 and the screen assembly 11 is defined by a side surface of the second raised part 24 away from the cover plate 17 and an end surface corresponding to the rear cover 12. The bonding part 29 filling in the fitting gap f5 glues the second raised part 24 and the rear cover 12. Certainly, the accommodating space Q2 and the fitting gap f5 are not communicated at this time.

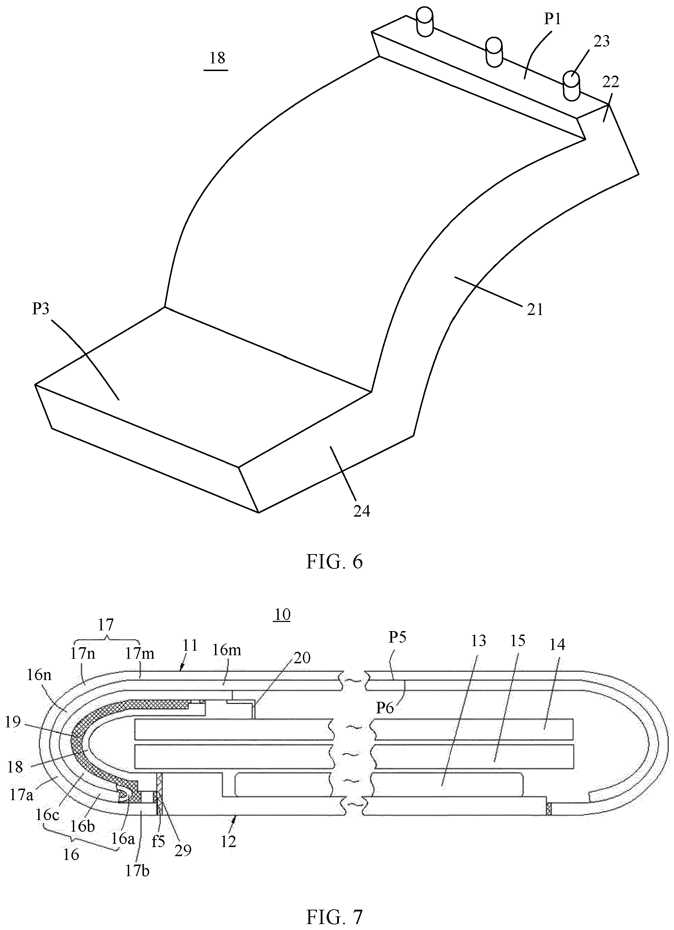

It should be noted that for the implementation shown in FIG. 5, an end surface of the second raised part 24 (corresponding to the second surface P2 in FIG. 3) may need to form a part of the outer contour of the electronic device 10. Therefore, the second supporting pads 25 may not be disposed. For a corresponding three-dimensional structure of the bracket 18, refer to FIG. 6.

Still refer to the implementation of FIG. 2. The display screen 16 includes a wire connecting screen section 16c, the main screen section 16b, and the bent section 16a. The main screen section 16b is a part of the display screen 16 used for on-screen display. The wire connecting screen section 16c is a part of the display screen 16 configured to connect the wire 20. The bent section 16a is a part of the display screen 16 connected between the main screen section 16b and the wire connecting screen section 16c. The main screen section 16b is attached to an inner side surface of the cover plate body 17a. The wire connecting screen section 16c is located on an inner side surface of the main screen section 16b, and is stacked on the main screen section 16b. The wire connecting screen section 16c may bond to the main screen section 16b by using adhesive. The extended plate section 17b extends beyond the main screen section 16b. The bracket body 21 is spaced apart from and opposite to the wire connecting screen section 16c to define first filling space Q3 (shown in FIG. 4). The second raised part 24 is spaced apart from and opposite to the bent section 16a to define second filling space Q4 (shown in FIG. 4). The second filling space Q4 is communicated with the first filling space Q3. The first gap f1 is communicated with the first filling space Q3. The second gap f2 is communicated with the second filling space Q4. By filling the first filling space Q3 and the second filling space Q4 with an adhesive material, the first filling space Q3, the second filling space Q4, the first gap f1, and the second gap f2 are filled, so that the display screen 16, the bracket 18, and the cover plate 17 are bonded into an integral structure, which greatly improves a protection effect of the bent section 16a of the display screen 16 in the accommodating space Q2. In addition, the first gap f1 and the second gap f2 that are communicated with the accommodating space Q2 are also conducive to outflow of gas in the accommodating space Q2 during adhesive filling, reducing a possibility that air bubbles left in the accommodating space Q2 affect the adhesive material filling, and then affect the bonding effect and cushioning protection effect. Still refer to FIG. 2 and FIG. 4. In some implementations, an inward recessed cavity C1 is formed on a surface of the bent section 16a away from a side of the cover plate 17 before bending. In a bending state of the display screen 16, the recessed cavity C1 defines a third filling space Q5. In this embodiment, a thickness of the bent section 16a of the display screen 16 is set to be smaller than that of the main screen section 16b, so that a side surface of the bent section 16a is recessed relative to the main screen section 16b to form the recessed cavity C1. The bent section 16a with smaller thickness is easy to bend. When an adhesive material is poured into the accommodating space Q2, the adhesive material may be filled into the third filling space Q5 defined by the recessed cavity C1. There is an adhesive material on an inner side of the bent section 16a, which limits the bent section 16a to further bend, and reduces a possibility of damage at a corner caused by excessive bending of the bent section 16a. Combined with the adhesive material wrapped on an outer side of the bent section 16a, the bent section 16a can be reliably maintained in a preset bent state, and a possibility of affecting structural performance of the bent section 16a by a change of a bending angle of the external force is reduced. In some implementation, another side surface of the bent section 16a (a surface of the bent section 16a near a side of the cover plate 17 before bending) may alternatively be disposed to an inward recessed structure relative to the main screen section 16b, so that a spacing between the side surface of the bent section 16a and the cover plate 17 is larger, and a thickness of an adhesive material filled in space between the spacing is increased. Therefore, the side of the bent section 16a is protected by an adhesive material with enough thickness, and safety to use the bent section 16a is further improved.

Still refer to FIG. 2. The cover plate 17 in the embodiment of this application includes a flat plate section 17m and an arcuate plate section 17n. The flat plate section 17m is a roughly flat plate-like part of the cover plate, which is generally located on the front of the electronic device 10 and corresponds to a middle display region of the electronic device 10. The arcuate plate section 17n is a part of the cover plate 17 formed by bending and extending along an arc direction from an edge of the flat plate section 17m. A curved angle of the arcuate plate section 17n is 90° to 180°. A dividing line L2 of the arcuate plate section 17n and the flat plate section 17m is shown in FIG. 2. The curved angle at this point is a radian value occupied by the arcuate plate section 17n. It should be noted that the cover plate 17 is artificially divided into the flat plate section 17m and the arcuate plate section 17n, and the cover plate is divided into the cover plate body 17a and the extended plate section 17b, which is only different division manners of the cover plate 17, and does not mean that the cover plate 17 independently has all sections. In this embodiment, the cover plate body 17a includes the flat plate section 17m and a part of the arcuate plate section 17n connected to the flat plate section 17m. The extended plate section 17b is a part of the arcuate plate section 17n extending beyond the bent section 16a. Correspondingly, the main screen section 16b of the display screen 16 includes a flat section 16m and a curved section 16n that are connected to each other. The bent section 16a is connected to one end of the curved section 16n away from the flat section 16m. The flat section 16m fits on a side on the flat plate section 17m at which the first plate surface P6 is located. The curved section 16n fits on a side on the arcuate plate section 17n at which the first plate surface P6 is located. Bonding between the display screen 16 and the cover plate 17 may be achieved by optical clear adhesive. A shape of the wire connecting screen section 16c includes an arc shape fitting with the curved section 16n. The wire connecting screen section is stacked on an inner side of the curved section 16n, for example, bonds to an inner side surface of the curved section 16n by using optical clear adhesive. An angle between a tangent direction at one end of the curved section 16n connected to the bent section 16a and the flat section 16m fits with the curved angle of the arcuate plate section 17n, around a range of 90° to 180°. Certainly, in some implementations, an end of the arcuate plate section 17n of the cover plate 17 has an extended plate section 17b. In these implementations, a curved angle of the display screen 16 is slightly smaller than a curved angle of the cover plate 17.

In the implementations shown in FIG. 2 to FIG. 6, a curved angle of the arcuate plate section 17n is roughly 120°, which limits the outer contour of a side surface of the electronic device 10, so that the front of the electronic device 10 is only visible on the cover plate 17, which is convenient for an all-screen design of the electronic device 10. Correspondingly, an extended angle of the bracket body 21 of the bracket 18 along an arc direction is also about 120°. The first raised part 22 is supported at a junction of the flat section 16m and the curved section 16n corresponding to the display screen 16. The second raised part 24 is supported at an end of the arcuate plate section 17n of the cover plate 17 or extends beyond the cover plate 17 and corresponds to the end surface of the cover plate 17.

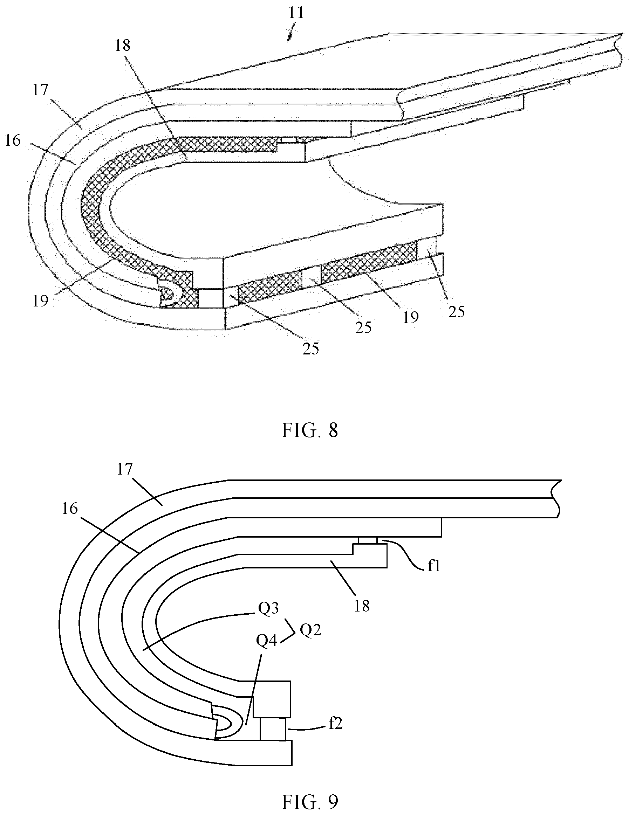

FIG. 7 to FIG. 10 show another implementation. A main difference between the implementation and implementations shown in FIG. 2 to FIG. 6 is the curved angle of the arcuate plate section 17n. To be specific, in the implementations of FIG. 2 to FIG. 6, the curved angle of the arcuate plate section 17n is roughly 120°, and the arcuate plate section extends only a side surface of the electronic device 10. In the implementation shown in FIG. 7 to FIG. 10, a curved angle of the arcuate plate section 17n is roughly 180°, and the arcuate plate section not only limits an outer contour an entire side surface of the electronic device 10, but also extends to the back of the electronic device 10. In this way, only the cover plate 17 may be visible from the front and side of the electronic device 10, and the all-screen design of the electronic device 10 may alternatively be achieved. Correspondingly, an extended angle of the bracket body 21 of the bracket 18 along an arc direction is also about 180°. The first raised part 22 is supported upward at the flat section 16m of the display screen 16. The second raised part 24 is supported downward at an end of the arcuate plate section 17n of the cover plate 17 (as shown) or extends beyond the cover plate 17 and corresponds to the end surface of the cover plate 17. In this implementation, a corresponding rear cover 12 only covers part of the back of the electronic device 10, may be flat, and not need to be arc-shaped upwarped at the end, which reduces a design and processing difficulty of the rear cover 12.

In some other implementations, the curved angle between the arcuate plate section 17n and the curved section 16n may alternatively be set at 0° to 90°.

An embodiment of this application also provides a screen assembly assembling method for forming the screen assembly 11 shown in FIG. 2 to FIG. 6, or the screen assembly 11 shown in FIG. 7 to FIG. 10. The screen assembly assembling method includes:
The bracket 18 and the cover plate 17 form the accommodating space Q2, and the bent section 16a is formed by bending the display screen 16 and is accommodated in the accommodating space Q2. Then, adhesive is poured into the accommodating space Q2, so that the bracket 18, the cover plate 17, and the bent section 16a bond into an integral whole. Certainly, the main screen section 16b and a part of the wire connecting screen section 16c connected to the bent section 16a may also be accommodated and adhesively fixed in the accommodating space Q2.

For the implementation having the first gap f1, the second gap f2, or the third gap f3, when adhesive is poured into the accommodating space Q2, an adhesive material may be filled from the accommodating space Q2 to the first gap f1, the second gap f2, or the third gap f3, to facilitate gases discharge in the accommodating space Q2 and bonding of a structure on both sides of the first gap f1, the second gap f2, or the third gap f3. An adhesive material that overflows the first gap f1, the second gap f2, or the third gap f3 may be removed by subsequent processes.

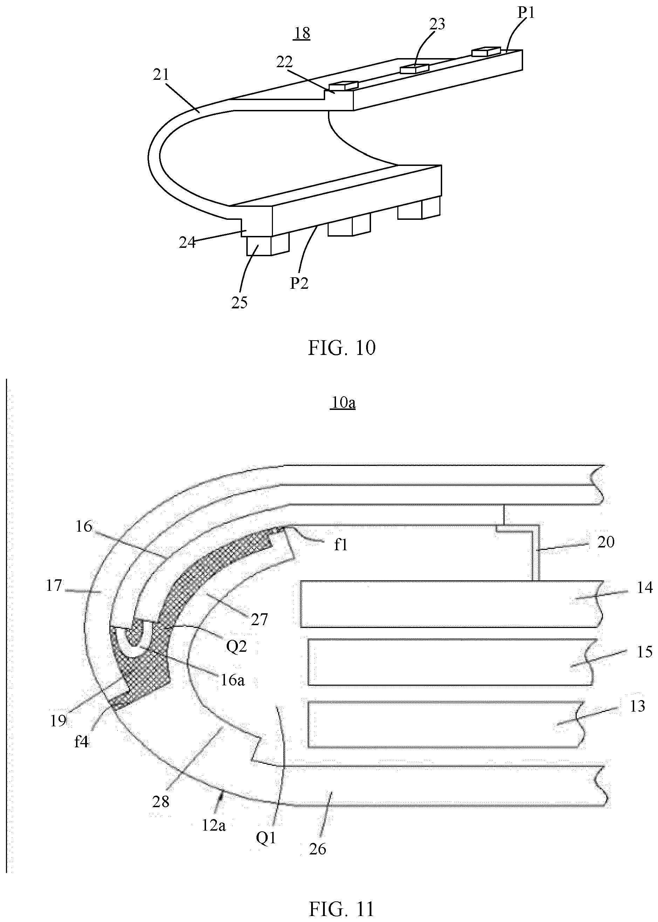

Refer to FIG. 11. An embodiment of this application also provides another electronic device 10a, including a display screen 16, a cover plate 17 and a rear cover 12a. Certainly, the device also includes common components, such as a battery 13, a mainboard 14, and a mainboard support 15. The display screen 16 may be connected to the mainboard 14 through a wire 20.

The display screen 16 of the electronic device 10a may use the display screen 16 in the electronic device 10, and has a bent section 16a formed by bending. The cover plate 17 may use the cover plate 17 and is located outside the display screen 16.

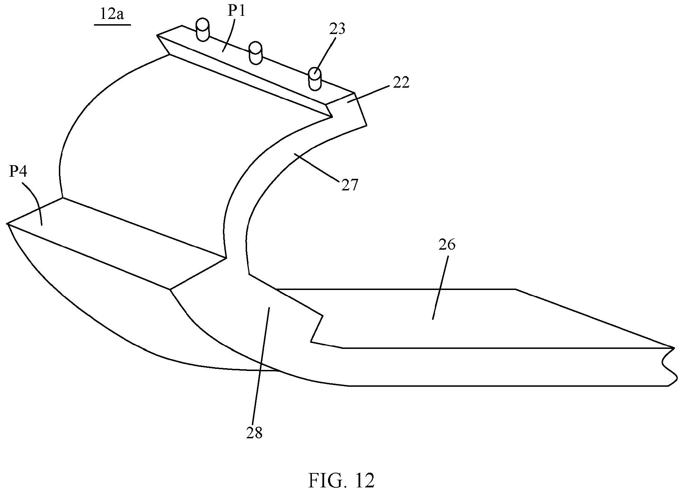

Refer to FIG. 11 and FIG. 12. The rear cover 12a includes a cover body 26 and a supporting part 27. The cover body 26 has an end surface P4 corresponding to the cover plate 17. An outer side of the end surface P4 corresponds to the cover plate 17. The cover body 26 and the cover plate 17 are fitted to form an internal space Q1, configured to install electronic components such as a battery 13, a mainboard 14, and a mainboard support 15. The display screen 16 is located in the internal space Q1. The cover body 26 has a rear cover end 28 facing the cover plate 17. The supporting part 27 is connected to the rear cover end 28 and extends into the internal space Q1. The supporting part 27 and the cover plate 17 form accommodating space Q2. The bent section 16a is located between the supporting part 27 and the cover plate 17 and extends into the accommodating space Q2. A filling structure 19 is provided in the accommodating space Q2, and is configured to fix the bent section 16a to the supporting part 27 and the cover plate 17.

The electronic device 10a, the supporting part 27 of the rear cover 12a, and the cover plate 17 form the accommodating space Q2 and form the filling structure 19 to support and protect the display screen 16, so that safety to use the display screen 16 can be effectively improved. In addition, after the rear cover 12a is assembled in place, only one adhesive bonding is needed to implement formation of the filling structure 19 used to protect the display screen 16 and to bond the rear cover 12a and the cover plate 17. Operation steps are reduced.

In the electronic device 10a, the supporting part 27 is a cantilever structure protruding from the cover body 26. A wall thickness of the supporting part 27 is 0.5 mm to 1.0 mm. In this implementation, the supporting part 27 is cantilevered out from the cover body 26. When the supporting part 27 or a whole rear cover 12a is made of a specific elastic material (such as a metal sheet and a plastic material with a specific elasticity), a cantilever extension part of the supporting part 27 has specific elastic deformability. In this way, the supporting part 27 provides elastic support for the display screen 16, and therefore not only supports the display screen 16 but also provides certain cushioning protection for the display screen 16. The supporting part 27 with a wall thickness of 0.5 mm to 1.0 mm can maintain a specific structure stiffness to provide support force. In addition, the supporting part has specific deformability to achieve elastic support for the display screen 16. Optionally, the supporting part 27 and the cover body 26 of the rear cover 12a may be integrally formed by a plastic material.

In the electronic device 10a, an end of the supporting part 27 away from the cover body 26 has a first raised part 22 protruding to a side of the display screen 16. The first raised part supports the display screen 16 in a direction of the cover plate 17. In this implementation, the first raised part 22 is disposed on a side of the supporting part 27 away from the cover body 26, that is, at a cantilever end of the supporting part 27, making a function of elastic supporting of the display screen 16. Optionally, a surface of the first raised part 22 corresponding to a side of the display screen 16 is a first surface P1. First supporting pads 23 are disposed on the first surface P1, and the first supporting pads 23 support the display screen 16, so that the first surface P1 is spaced apart from the display screen 16 to define a first gap f1. The first gap f1 is communicated with the accommodating space Q2. When adhesive is poured into the accommodating space Q2, air in the accommodating space Q2 may be discharged from the first gap f1, facilitating filling with an adhesive material. In addition, an excessive adhesive material may be poured to make the adhesive material overflow from the first gap f1 to ensure that the adhesive material in the accommodating space Q2 is filled, and the adhesive material left in the first gap f1 may be used to bond the first surface P1, the first supporting pads 23, and the display screen 16.

In the electronic device 10a, the supporting part 27 is connected to a side of the rear cover end 28 near the internal space Q1. The end surface P4 of a side of the rear cover end 28 far away from the internal space Q1 corresponds to the cover plate 17.

In this way, when the electronic device 10a is assembled, a fourth gap f4 is left between the end surface P4 of the rear cover end 28 and an end surface of the cover plate 17, the supporting part 27 extends into an inner side of the display screen 16, the first gap f1 is left between an end surface of the first raised part 22 and the display screen 16, and the supporting part 27, the cover plate 17, and the rear cover end 28 form the accommodating space Q2, and the accommodating space Q2 is communicated with the first gap f1 and the fourth gap f4 separately. Then, an adhesive material is poured into the accommodating space Q2, filling the accommodating space Q2 and overflowing from the first gap f1 and the fourth gap f4. An adhesive material that overflows from the fourth f4 gap may be removed by subsequent processes. The rear cover 12a, the bent section 16a, and the cover plate 17 are adhesively integrated near the accommodating space Q2 by using filled an adhesive material. A reliable protection structure for the bent section 16a is formed while completing assembly of the rear cover 12a and the cover plate 17 of the electronic device 10a.

According to the above description, the screen assembly 11 and the electronic devices 10 and 10a in embodiments of this application can provide reliable protection for the bent section 16a of the display screen 16 to effectively reduce a possibility of the bent section 16a being damaged by external impact.

The foregoing implementations are merely intended for describing the technical solutions of this application but not for limiting this application. Although this application is described in detail with reference to the exemplary implementations, a person of ordinary skill in the art should understand that modifications or equivalent replacements may be made to the technical solutions of this application without departing from the scope of this application.

## Claims

1. An electronic device (10), comprising:
a cover plate (17), wherein a surface of a side of the cover plate (17) is a first plate surface (P6);
a display screen (16), wherein the display screen (16) is located on a side at which the first plate surface (P6) of the cover plate (17) is located, the display screen (16) has a bent section (16a), and the bent section (16a) bends toward a side away from the cover plate (17); and
a bracket (18) located on a side of the display screen (16) away from the cover plate (17), wherein accommodating space (Q2) is provided between the bracket (18) and the cover plate (17) and wherein the bent section (16a) is located between the bracket (18) and the cover plate (17) and extends into the accommodating space (Q2),
a gap (f2, f3) that is communicated with the accommodating space (Q2) is defined between an end of the bracket (18) and the cover plate (17), and a filling structure (19) is provided in the accommodating space (Q2) and is configured to fix the bent section (16a) in the accommodating space (Q2), wherein the filling structure (19) comprises an adhesive material and is formed by pouring adhesive into the accommodating space (Q2) in which the bent section (16a) is already accommodated, wherein the adhesive material is filled from the accommodating space (Q2) to the gap (f2, f3) that is communicated with the accommodating space (Q2).

2. The electronic device (10) according to claim 1, wherein the bracket (18) comprises a bracket body (21) and a raised part (22, 24), the raised part (22, 24) is located at an end of the bracket body (21), and the raised part (22, 24) protrudes from the bracket body (21) toward the cover plate (17).

3. The electronic device (10) according to claim 2, wherein the cover plate (17) comprises a cover plate body (17a) and an extended plate section (17b), the cover plate body (17a) and the extended plate section (17b) are two regions of the cover plate (17), and the raised part (24) protrudes from the bracket body (21) toward the extended plate section (17b).

4. The electronic device (10) according to claim 3, wherein the raised part (24) has a surface (P2) corresponding to the extended plate section (17b), and the gap (f2) that is communicated with the accommodating space (Q2) is defined between the extended plate section (17b) and the surface (P2) that is of the raised part (24) and that corresponds to the extended plate section (17b).

5. The electronic device (10) according to claim 2, wherein the raised part (22, 24) is spaced apart from the bent section (16a).

6. The electronic device (10) according to any one of claims 1 to 5, wherein the display screen (16) further comprises a main screen section (16b), the bent section (16a) is bent from an edge of the main screen section (16b) to the side away from the cover plate (17), the bent section (16a) extends from the main screen section (16b) into the accommodating space (Q2), and the main screen section (16b) is a part of the display screen (16) for displaying.

7. The electronic device (10) according to claim 6, wherein a thickness of the bent section (16a) is smaller than a thickness of the main screen section (16b).

8. The electronic device (10) according to claim 6 or 7, wherein the display screen (16) further comprises a wire connecting screen section (16c), the wire connecting screen section (16c) is connected to the bent section (16a), the main screen section (16b) is attached to an inner side surface of the cover plate body (17a), and the wire connecting screen section (16c) is located on an inner side surface of the main screen section (16b) and is stacked on the main screen section (16b).

9. The electronic device (10) according to claim 1, wherein a recessed cavity (C1) is formed on a side of the bent section (16a), the recessed cavity (C1) defines a filling space (Q5), and the accommodating space (Q2) comprises the filling space (Q5).

10. The electronic device (10) according to claim 9, wherein there is an adhesive material in the filling space (Q5).

11. The electronic device (10) according to claim 3, wherein supporting pads (25) are convexly disposed on the surface (P2) that is of the raised part (24) and that corresponds to the extended plate section (17b), the supporting pads (25) support the extended plate section (17b), so that the extended plate section (17b) is spaced apart from the surface (P2) that is of the raised part (24) and that corresponds to the extended plate section (17b) to define the gap (f2) that is communicated with the accommodating space (Q2);
there are a plurality of supporting pads (25), the plurality of supporting pads (25) are disposed at intervals in sequence, and the gap (f2) that is communicated with the accommodating space (Q2) comprises interval space between adjacent supporting pads (25).

12. The electronic device (10) according to claim 2, wherein the raised part (24) extends to an end surface of the cover plate (17), and the raised part (24) is opposite to the end surface of the cover plate (17).

13. The electronic device (10) according to claim 12, wherein the raised part (24) has a surface opposite to the end surface of the cover plate (17), the surface that is of the raised part (24) and that is opposite to the end surface of the cover plate (17) is spaced apart from the end surface of the cover plate (17) to define the gap (f3) that is communicated with the accommodating space (Q2).

## Patentansprüche

1. Elektronische Vorrichtung (10), umfassend:
eine Abdeckplatte (17), wobei eine Oberfläche einer Seite der Abdeckplatte (17) eine erste Plattenoberfläche (P6) ist;
einen Anzeigebildschirm (16), wobei der Anzeigebildschirm (16) auf einer Seite angeordnet ist, an der sich die erste Plattenoberfläche (P6) der Abdeckplatte (17) befindet, wobei der Anzeigebildschirm (16) einen gebogenen Abschnitt (16a) aufweist und der gebogene Abschnitt (16a) zu einer Seite hin gebogen ist, die von der Abdeckplatte (17) weg weist; und
eine Halterung (18), die auf einer Seite des Anzeigebildschirms (16) angeordnet ist, die von der Abdeckplatte (17) weg weist, wobei ein Aufnahmeraum (Q2) zwischen der Halterung (18) und der Abdeckplatte (17) vorgesehen ist und wobei der gebogene Abschnitt (16a) zwischen der Halterung (18) und der Abdeckplatte (17) angeordnet ist und sich in den Aufnahmeraum (Q2) erstreckt,
wobei ein Spalt (f2, f3), der mit dem Aufnahmeraum (Q2) in Verbindung steht, zwischen einem Ende der Halterung (18) und der Abdeckplatte (17) definiert ist, und wobei eine Füllstruktur (19) in dem Aufnahmeraum (Q2) vorgesehen und dazu konfiguriert ist, den gebogenen Abschnitt (16a) in dem Aufnahmeraum (Q2) zu fixieren, wobei die Füllstruktur (19) ein Klebematerial umfasst und durch Gießen von Klebstoff in den Aufnahmeraum (Q2) gebildet wird, in dem der gebogene Abschnitt (16a) bereits aufgenommen ist, wobei das Klebematerial von dem Aufnahmeraum (Q2) bis zu dem Spalt (f2, f3), der mit dem Aufnahmeraum (Q2) in Verbindung steht, eingefüllt ist.

2. Elektronische Vorrichtung (10) nach Anspruch 1, wobei die Halterung (18) einen Halterungskörper (21) und ein erhabenes Teil (22, 24) umfasst, das erhabene Teil (22, 24) an einem Ende des Halterungskörpers (21) angeordnet ist und das erhabene Teil (22, 24) von dem Halterungskörper (21) in Richtung der Abdeckplatte (17) hervorsteht.

3. Elektronische Vorrichtung (10) nach Anspruch 2, wobei die Abdeckplatte (17) einen Abdeckplattenkörper (17a) und einen erweiterten Plattenabschnitt (17b) umfasst, der Abdeckplattenkörper (17a) und der erweiterte Plattenabschnitt (17b) zwei Bereiche der Abdeckplatte (17) sind und das erhabene Teil (24) von dem Halterungskörper (21) in Richtung des erweiterten Plattenabschnitts (17b) hervorsteht.

4. Elektronische Vorrichtung (10) nach Anspruch 3, wobei das erhabene Teil (24) eine Oberfläche (P2) aufweist, die dem erweiterten Plattenabschnitt (17b) entspricht, und der Spalt (f2), der mit dem Aufnahmeraum (Q2) in Verbindung steht, zwischen dem erweiterten Plattenabschnitt (17b) und der Oberfläche (P2), die zu dem erhabenen Teil (24) gehört und die dem erweiterten Plattenabschnitt (17b) entspricht, definiert ist.

5. Elektronische Vorrichtung (10) nach Anspruch 2, wobei das erhabene Teil (22, 24) von dem gebogenen Abschnitt (16a) beabstandet ist.

6. Elektronische Vorrichtung (10) nach einem der Ansprüche 1 bis 5, wobei der Anzeigebildschirm (16) ferner einen Hauptbildschirmabschnitt (16b) umfasst, wobei der gebogene Abschnitt (16a) von einer Kante des Hauptbildschirmabschnitts (16b) zu der von der Abdeckplatte (17) abgewandten Seite gebogen ist, wobei sich der gebogene Abschnitt (16a) vom Hauptbildschirmabschnitt (16b) in den Aufnahmeraum (Q2) erstreckt und der Hauptbildschirmabschnitt (16b) ein Teil des Anzeigebildschirms (16) zum Anzeigen ist.

7. Elektronische Vorrichtung (10) nach Anspruch 6, wobei eine Dicke des gebogenen Abschnitts (16a) geringer ist als eine Dicke des Hauptbildschirmabschnitts (16b).

8. Elektronische Vorrichtung (10) nach Anspruch 6 oder 7, wobei der Anzeigebildschirm (16) ferner einen Leitungsverbindungs-Bildschirmabschnitt (16c) umfasst, wobei der Leitungsverbindungs-Bildschirmabschnitt (16c) mit dem gebogenen Abschnitt (16a) verbunden ist, der Hauptbildschirmabschnitt (16b) an einer inneren Seitenfläche des Abdeckplattenkörpers (17a) befestigt ist und der Leitungsverbindungs-Bildschirmabschnitt (16c) auf einer inneren Seitenfläche des Hauptbildschirmabschnitts (16b) angeordnet und auf dem Hauptbildschirmabschnitt (16b) gestapelt ist.

9. Elektronische Vorrichtung (10) nach Anspruch 1, wobei ein vertiefter Hohlraum (C1) auf einer Seite des gebogenen Abschnitts (16a) ausgebildet ist, wobei der vertiefte Hohlraum (C1) einen Füllraum (Q5) definiert und der Aufnahmeraum (Q2) den Füllraum (Q5) umfasst.

10. Elektronische Vorrichtung (10) nach Anspruch 9, wobei sich ein Klebematerial im Füllraum (Q5) befindet.

11. Elektronische Vorrichtung (10) nach Anspruch 3, wobei Stützpolster (25) konvex auf der Fläche (P2) angeordnet sind, die zu dem erhabenen Teil (24) gehört und die dem erweiterten Plattenabschnitt (17b) entspricht, wobei die Stützpolster (25) den erweiterten Plattenabschnitt (17b) stützen, sodass der erweiterte Plattenabschnitt (17b) von der Fläche (P2) beabstandet ist, die zu dem erhabenen Teil (24) gehört und die dem erweiterten Plattenabschnitt (17b) entspricht, um den Spalt (f2) zu definieren, der mit dem Aufnahmeraum (Q2) in Verbindung steht;
es eine Vielzahl von Stützpolstern (25) gibt, wobei die Vielzahl von Stützpolstern (25) in Abständen hintereinander angeordnet ist und der Spalt (f2), der mit dem Aufnahmeraum (Q2) in Verbindung steht, einen Zwischenraum zwischen benachbarten Stützpolstern (25) umfasst.

12. Elektronische Vorrichtung (10) nach Anspruch 2, wobei sich der erhabene Teil (24) zu einer Endfläche der Abdeckplatte (17) erstreckt und der erhabene Teil (24) der Endfläche der Abdeckplatte (17) gegenüberliegt.

13. Elektronische Vorrichtung (10) nach Anspruch 12, wobei der erhabene Teil (24) eine der Endfläche der Abdeckplatte (17) gegenüberliegende Oberfläche aufweist, wobei die Oberfläche des erhabenen Teils (24), die der Endfläche der Abdeckplatte (17) gegenüberliegt, von der Endfläche der Abdeckplatte (17) beabstandet ist, um den Spalt (f3) zu definieren, der mit dem Aufnahmeraum (Q2) in Verbindung steht.

## Revendications

1. Dispositif électronique (10), comprenant :
une plaque de couverture (17), dans lequel une surface d'un côté de la plaque de couverture (17) est une première surface de plaque (P6) ;
un écran d'affichage (16), dans lequel l'écran d'affichage (16) est situé sur un côté où se trouve la première surface de plaque (P6) de la plaque de couverture (17), l'écran d'affichage (16) comporte une section pliée (16a), et la section pliée (16a) se plie vers un côté opposé à la plaque de couverture (17) ; et
un support (18) situé sur un côté de l'écran d'affichage (16) opposé à la plaque de couverture (17), dans lequel un espace de logement (Q2) est prévu entre le support (18) et la plaque de couverture (17) et dans lequel la section pliée (16a) est située entre le support (18) et la plaque de couverture (17) et s'étend dans l'espace de logement (Q2),
un espace (f2, f3) qui communique avec l'espace de logement (Q2) est défini entre une extrémité du support (18) et la plaque de couverture (17), et une structure de remplissage (19) est prévue dans l'espace de logement (Q2) et est configurée pour fixer la section pliée (16a) dans l'espace de logement (Q2), dans lequel la structure de remplissage (19) comprend un matériau adhésif et est formée en versant de l'adhésif dans l'espace de logement (Q2) dans lequel la section pliée (16a) est déjà logée, dans lequel le matériau adhésif est rempli depuis l'espace de logement (Q2) jusqu'à l'espace (f2, f3) qui communique avec l'espace de logement (Q2).

2. Dispositif électronique (10) selon la revendication 1, dans lequel le support (18) comprend un corps de support (21) et une partie surélevée (22, 24), la partie surélevée (22, 24) est située à une extrémité du corps de support (21), et la partie surélevée (22, 24) fait saillie depuis le corps de support (21) vers la plaque de couverture (17).

3. Dispositif électronique (10) selon la revendication 2, dans lequel la plaque de couverture (17) comprend un corps de plaque de couverture (17a) et une section de plaque étendue (17b), le corps de plaque de couverture (17a) et la section de plaque étendue (17b) sont deux régions de la plaque de couverture (17), et la partie surélevée (24) fait saillie depuis le corps de support (21) vers la section de plaque étendue (17b).

4. Dispositif électronique (10) selon la revendication 3, dans lequel la partie surélevée (24) a une surface (P2) correspondant à la section de plaque étendue (17b), et l'interstice (f2) qui communique avec l'espace de logement (Q2) est défini entre la section de plaque étendue (17b) et la surface (P2) de la partie surélevée (24) qui correspond à la section de plaque étendue (17b).

5. Dispositif électronique (10) selon la revendication 2, dans lequel la partie surélevée (22, 24) est espacée de la section pliée (16a).

6. Le dispositif électronique (10) selon l'une quelconque des revendications 1 à 5, dans lequel l'écran d'affichage (16) comprend en outre une section d'écran principale (16b), la section pliée (16a) est pliée depuis un bord de la section d'écran principale (16b) vers le côté opposé à la plaque de couverture (17), la section pliée (16a) s'étend depuis la section d'écran principale (16b) dans l'espace de logement (Q2), et la section d'écran principale (16b) est une partie de l'écran d'affichage (16) destinée à l'affichage.

7. Le dispositif électronique (10) selon la revendication 6, dans lequel une épaisseur de la section pliée (16a) est inférieure à une épaisseur de la section d'écran principale (16b).

8. Le dispositif électronique (10) selon la revendication 6 ou 7, dans lequel l'écran d'affichage (16) comprend en outre une section d'écran de connexion filaire (16c), la section d'écran de connexion filaire (16c) est connectée à la section pliée (16a), la section d'écran principale (16b) est fixée à une surface latérale intérieure du corps de plaque de couverture (17a), et la section d'écran de connexion filaire (16c) est située sur une surface latérale intérieure de la section d'écran principale (16b) et est empilée sur la section d'écran principale (16b).

9. Le dispositif électronique (10) selon la revendication 1, dans lequel une cavité évidée (C1) est formée sur un côté de la section pliée (16a), la cavité évidée (C1) définit un espace de remplissage (Q5), et l'espace de logement (Q2) comprend l'espace de remplissage (Q5).

10. Le dispositif électronique (10) selon la revendication 9, dans lequel un matériau adhésif est présent dans l'espace de remplissage (Q5).

11. Dispositif électronique (10) selon la revendication 3, dans lequel des patins de support (25) sont disposés de manière convexe sur la surface (P2) de la partie surélevée (24) qui correspond à la section de plaque étendue (17b), les patins de support (25) supportent la section de plaque étendue (17b), de sorte que la section de plaque étendue (17b) soit espacée de la surface (P2) de la partie surélevée (24) pour définir l'interstice (f2) qui communique avec l'espace de logement (Q2) ;
dans lequel il existe une pluralité de patins de support (25) disposés à intervalles de manière séquentielle, et l'interstice (f2) qui communique avec l'espace de logement (Q2) comprend des espaces d'intervalle entre des patins de support (25) adjacents.

12. Le dispositif électronique (10) selon la revendication 2, dans lequel la partie surélevée (24) s'étend jusqu'à une surface d'extrémité de la plaque de couverture (17), et la partie surélevée (24) est opposée à la surface d'extrémité de la plaque de couverture (17).

13. Dispositif électronique (10) selon la revendication 12, dans lequel la partie surélevée (24) présente une surface opposée à la surface d'extrémité de la plaque de couverture (17), ladite surface de la partie surélevée (24) étant espacée de la surface d'extrémité de la plaque de couverture (17) pour définir l'interstice (f3) qui communique avec l'espace de logement (Q2).
